# EUROPÄISCHE PATENTANMELDUNG

(11) **EP 0 974 846 A2**
(43) Veröffentlichungstag der Anmeldung: **26.01.2000**
(21) Anmeldenummer: 99810570.4
(22) Anmeldetag: 02.07.1999
(51) Int. Cl.: G01R 31/12

(54) **Verfahren zum Feststellen von Einbau- und/oder Kalibrierungsfehlern einer Mehrzahl von Signalauskopplungseinheiten eines oder mehreren Teilentladungsmesssysteme**

(30) Priorität: 18.07.1998 DE 19832387
(71) Anmelder: Asea Brown Boveri AG, 5401 Baden (CH)
(72) Erfinder: Bertheau, Tom, 79761 Waldshut (DE); Ruhe, Jörg, 5315 Böttstein (CH); Füglister, Thomas, 5200 Brugg (CH)
(74) Vertreter: Kaiser, Helmut, Dr.

(57) **Zusammenfassung**

Ein Verfahren zum Feststellen von Einbau- und/oder Kalibrierungsfehlern einer Mehrzahl von Signalauskopplungseinheiten (S1,..,S3) eines oder mehrerer Teilentladungsmesssysteme, welche Signalauskopplungseinheiten (S1,..,S3) an verschiedenen Stellen eines für Hochspannung ausgelegten elektrischen Isolationssystems (10) angeordnet sind, ist gekennzeichnet durch die folgenden Schritte:
(a) Kalibrieren einer ausgewählten der Signalauskopplungseinheiten (S1,..,S3) durch Injektion eines Kalibrierimpulses zwischen der Hochspannungsseite des Isolationssystems (10) und Erde;
(b) Abspeichern der so erhaltenen Kalibrierdaten;
(c) Aufnehmen und Abspeichern der Entladungsdaten bzw. der Amplitude des Kalibrierimpulses mittels der ausgewählten Signalauskopplungseinheit;
(d) Uebernahme der abgespeicherten Kalibrierdaten der ausgewählten Signalauskopplungseinheit für die Kalibrierung der anderen Signalauskopplungseinheiten;
(e) Aufnehmen und Abspeichern der Entladungsdaten bzw. der Amplitude des Kalibrierimpulses mittels der anderen Signalauskopplungseinheiten; und
(f) Vergleich der abgespeicherten Entladungsdaten aller Signalauskopplungseinheiten miteinander.

## Beschreibung

### TECHNISCHES GEBIET

Die vorliegende Erfindung bezieht sich auf das Gebiet der elektrischen Isolationsmesstechnik. Sie betrifft ein Verfahren zum Feststellen von Einbau- und/oder Kalibrierungsfehlern einer Mehrzahl von Signalauskopplungseinheiten eines oder mehrerer Teilentladungsmesssysteme, welche Signalauskopplungseinheiten an verschiedenen Stellen eines für Hochspannung ausgelegten elektrischen Isolationssystems oder in verschiedenen Isolationssystemen gleicher Bauart angeordnet sind.

### STAND DER TECHNIK

Bei der Ueberprüfung der elektrischen Isolation von Hochspannungsisolationssystemen, wie sie z.B. bei der Statorwicklung von Generatoren oder bei Hochspannungstransformatoren vorliegen, ist es - insbesondere im Falle mehrphasiger Systeme oder mehrerer einphasiger Systeme gleicher Bauart - häufig notwendig, Teilentladungsmessungen an verschiedenen Stellen des Systems vorzunehmen. Hierzu werden an den zu messenden Stellen Signalauskopplungseinheiten angeordnet bzw. eingebaut, die entsprechende Teilentladungssignale auskoppeln und entweder an eigenes Teilentladungsmesssystem oder - umschaltbar - an ein zentrales Teilentladungsmesssystem weiterleiten. Damit die von den einzelnen Signalauskopplungseinheiten ausgekoppelten Signale miteinander verglichen und sinnvoll korreliert werden können, ist es notwendig, an allen Messstellen gleichartige Messbedingungen herzustellen. Hierzu gehört nicht nur der richtige Einbau der jeweiligen Einheit, sondern auch eine Kalibrierung, die mit der Kalibrierung der anderen Einheiten übereinstimmt bzw. kompatibel ist.

### DARSTELLUNG DER ERFINDUNG

Es ist daher Aufgabe der Erfindung, ein Verfahren anzugeben, mit welchen auf einfache und sichere Weise festgestellt werden kann, ob bei den verschiedenen Signalauskopplungseinheiten störende Einbau- und Kalibrierungsfehler vorhanden sind.

Die Aufgabe wird durch die Gesamtheit der Merkmale des Anspruchs 1 gelöst.

Eine erste bevorzugte Ausführungsform des erfindungsgemässen Verfahrens zeichnet sich dadurch aus, dass das Isolationssystem eine Mehrphasensystem ist, und dass die einzelnen Signalauskopplungseinheiten an den verschiedenen Phasen des Isolationssystems angeordnet sind. Eine zweite bevorzugte Ausführungsform ist dadurch gekennzeichnet, dass die verschiedenen Isolationssysteme einphasige Isolationssysteme gleicher Bauart sind, und dass die einzelnen Signalauskopplungseinheiten jeweils in den verschiedenen Isolationssystemen angeordnet sind.

Weitere Ausführungsformen ergeben sich aus den abhängigen Ansprüchen.

### KURZE ERLÄUTERUNG DER FIGUREN

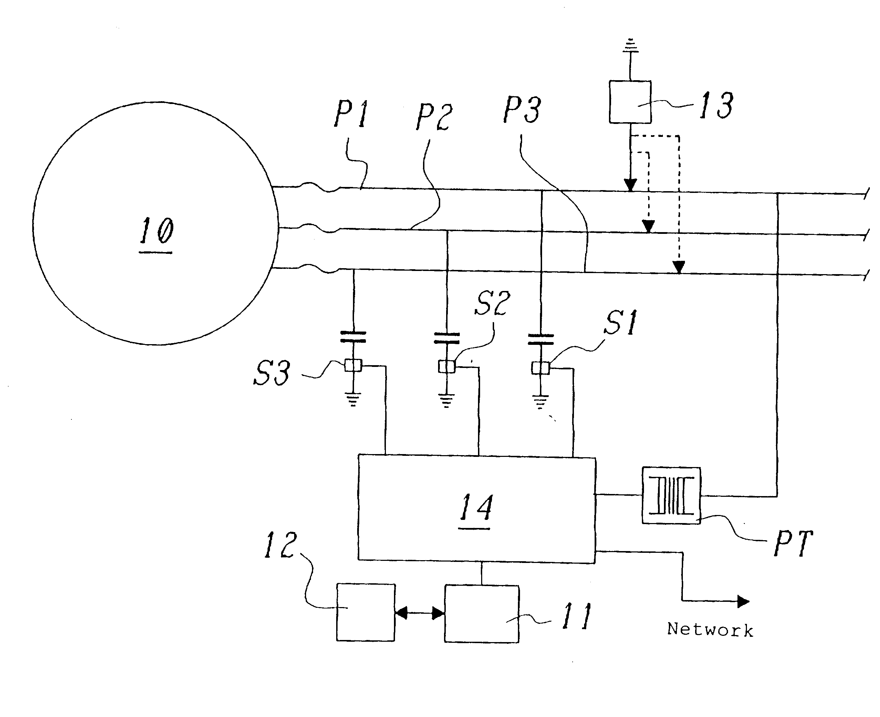

Die Erfindung soll nachfolgend anhand eines Ausführungsbeispiels im Zusammenhang mit der Zeichnung näher erläutert werden. Die einzige Figur zeigt eine beispielhafte Messanordnung, mit der bei einem 3-phasigen Generator das erfindungsgemässe Verfahren durchgeführt werden kann.

### WEGE ZUR AUSFÜHRUNG DER ERFINDUNG

In der Figur ist eine Kalibrieranordnung für ein Teilentladungsmesssystem wiedergegeben, mit welcher die Isolation eines hochspannungsisolierten, 3-phasigen Generators 10 überprüft werden kann. Der Generator 10 hat intern eine 3-phasige isolierte Wicklung, deren einzelne Phasen P1,..,P3 nach aussen geführt und z.B. mit einem (nicht dargestellten) Netz verbunden werden können. An jede der 3 Phasen P1,..,P3 ist eine (kapazitive und/oder induktive) Signalauskopplungseinheit S1,..,S3 angeschlossen, mit der Teilentladungssignale ausgekoppelt und über eine entsprechende Anschlusseinrichtung 14 wahlweise an ein zentrales Teilentladungsmessgerät 11 weitergeleitet werden können. Das Teilentladungsmessgerät 11 seinerseits ist mit einem Datenspeicher 12 verbunden, in welchem Ergebnisse der Messung und Kalibrierung abgespeichert werden können. Selbstverständlich kann der Datenspeicher 12 auch Teil des Teilentladungsmessgerätes 11 und/oder der Anschlusseinrichtung 14 sein.

Für die Kalibrierung der Signalauskopplungseinheiten S1,..,S3 wird das Teilentladungsmessgerät 11 auf einen entsprechenden Kalibrierimpuls synchronisiert. Für die Synchronisierung im Normalbetrieb ist eine an die Anschlusseinrichtung 14 angeschlossene Synchronisiereinrichtung PT vorgesehen. Für die Synchronisation des Systems während der Kalibrierung ist die Anschlusseinrichtung 14 zusätzlich an das normale Netz angeschlossen. Für die Injektion eines Kalibrierimpulses steht ein Kalibrierimpulsgeber 13 zur Verfügung.

Die Ueberprüfung der Signalauskopplungseinheiten S1,..,S3 geht nun wie folgt vor sich:
Der Generator 10 wird für die gesamte beschrieben Prozedur vom Netz getrennt und während Umbauarbeiten aus Sicherheitsgründen geerdet und während der eigentlichen Kalibriervorgänge von Erde getrennt. In einem ersten Schritt wird eine ausgewählte der Signalauskopplungseinheiten S1,..,S3, z.B. die Signalauskopplungseinheit S1, durch Injektion eines Kalibrierimpulses mit dem Kalibrierimpulsgeber 13 zwischen der Hochspannungsseite der Signalauskopplungseinheit einer ersten Phase (z.B. P1) und Erde kalibriert. Die so erhaltenen Kalibrierdaten werden in dem Datenspeicher 12 abgespeichert. Anschliessend werden mit dieser ausgewählten Signalauskopplungseinheit (S1 ) die Entladungsdaten bzw. die Amplitude des Kalibrierimpulses aufgenommen und ebenfalls im Datenspeicher 12 abgespeichert.

In einem weiteren Schritt werden die abgespeicherten Kalibrierdaten der ausgewählten Signalauskopplungseinheit (S1 ) für die Kalibrierung der anderen Signalauskopplungseinheiten (S2, S3) übernommen, d.h. zur Kalibrierung der anderen Signalauskopplungseinheiten verwendet. Mit den so kalibrierten anderen Signalauskopplungseinheiten (S2, S3) werden dann ebenfalls die Entladungsdaten bzw. die Amplitude des Kalibrierimpulses (bei Einspeisung des Kalibrierimpulses an der jeweiligen Phase) aufgenommen und im Datenspeicher 12 abgespeichert. Zuguterletzt werden die abgespeicherten (zeit- oder phasenaufgelösten) Entladungsdaten bzw. Amplituden aller Signalauskopplungseinheiten S1,..,S3 miteinander manuelle oder mittels eines mathematischen (Güte-)Kriteriums verglichen. Wenn sie nicht gleich aussehen bzw. das mathematische (Güte-)Kriterium nicht erfüllt wird, existiert ein Einbau- und/oder Kalibrierfehler, der dann korrigiert werden muss, um später korrekte Messergebnisse über die Isolation des Systems zu erhalten.

Werden anstelle eines mehrphasigen Isolationssystems mehrere einphasige Isolationssysteme gleicher Bauart geprüft, werden die oben beschriebenen Schritte für die Signalauskopplungseinheiten in den verschiedenen Isolationssystemen durchgeführt.

Insgesamt ergibt sich mit der Erfindung ein besonders einfaches und wirkungsvolles Verfahren, mit welchem Einbau- und/oder Kalibrierfehler bei einem Teilentladungsmesssystem mit mehreren Signalauskopplungseinheiten festgestellt werden können. Es versteht sich von selbst, dass anstelle des im Beispiel behandelten Generators ein Transformator, ein Motor oder eine andere elektrische Einrichtung mit Hochspannungs-Isolierung Messobjekt des Teilentladungsmesssystems sein kann.

### BEZUGSZEICHENLISTE

- 10: Generator (mit Hochspannungs-lsolationssystem)
- 11: Teilentladungsmessgerät
- 12: Datenspeicher
- 13: Kalibrierimpulsgeber
- 14: Anschlusseinrichtung (mit manuellem oder automatischem Umschalter
- P1,..,P3: Phase
- PT: Synchronisiereinrichtung
- S1,..,S3: Signalauskopplungseinheit

## Patentansprüche

1. Verfahren zum Feststellen von Einbau- und/oder Kalibrierungsfehlern einer Mehrzahl von Signalauskopplungseinheiten (S1,..,S3) eines oder mehrerer Teilentladungsmesssysteme, welche Signalauskopplungseinheiten (S1,..,S3) an verschiedenen Stellen eines für Hochspannung ausgelegten elektrischen Isolationssystems (10) oder in verschiedenen Isolationssystemen gleicher Bauart angeordnet sind, gekennzeichnet durch die folgenden Schritte:
(a) Kalibrieren einer ausgewählten der Signalauskopplungseinheiten (S1,..,S3) durch Injektion eines Kalibrierimpulses zwischen der Hochspannungsseite des Isolationssystems (10) und Erde;
(b) Abspeichern der so erhaltenen Kalibrierdaten;
(c) Aufnehmen und Abspeichern der Entladungsdaten bzw. der Amplitude des Kalibrierimpulses mittels der ausgewählten Signalauskopplungseinheit;
(d) Uebernahme der abgespeicherten Kalibrierdaten der ausgewählten Signalauskopplungseinheit für die Kalibrierung der anderen Signalauskopplungseinheiten;
(e) Aufnehmen und Abspeichern der Entladungsdaten bzw. der Amplitude des Kalibrierimpulses mittels der anderen Signalauskopplungseinheiten; und
(f) Vergleich der abgespeicherten Entladungsdaten aller Signalauskopplungseinheiten miteinander.

2. Verfahren nach Anspruch 1, dadurch gekennzeichnet, dass das Isolationssystem (10) eine Mehrphasensystem ist, und dass die einzelnen Signalauskopplungseinheiten an den verschiedenen Phasen (P1,..,P3) des Isolationssystems (10) angeordnet sind.

3. Verfahren nach Anspruch 1, dadurch gekennzeichnet, dass die verschiedenen Isolationssysteme einphasige Isolationssysteme gleicher Bauart sind, und dass die einzelnen Signalauskopplungseinheiten jeweils an den verschiedenen Isolationssystemen angeordnet sind.

4. Verfahren nach einem der Ansprüche 2 und 3, dadurch gekennzeichnet, dass die Isolationssysteme eine rotierende elektrische Maschine, insbesondere einen Generator (10), umfassen.
